# EUROPÄISCHE PATENTSCHRIFT

(11) **EP 3 058 425 B1**
(45) Veröffentlichungstag und Bekanntmachung des Hinweises auf die Patenterteilung: **25.12.2019**
(21) Anmeldenummer: 14793844.3
(22) Anmeldetag: 04.11.2014
(51) Int. Cl.: G05B 17/02, G05B 19/418, G06F 17/50

(54) **VORRICHTUNG UND VERFAHREN ZUR ÄNDERUNG VON BETRIEBSEINSTELLUNGEN EINER TECHNISCHEN ANLAGE**
DEVICE AND METHOD FOR CHANGING OPERATING SETTINGS OF A TECHNICAL INSTALLATION
DISPOSITIF ET PROCÉDÉ PERMETTANT DE MODIFIER LES RÉGLAGES OPÉRATIONNELS D'UNE INSTALLATION TECHNIQUE

(30) Priorität: 03.12.2013 DE 102013224700
(43) Veröffentlichungstag der Anmeldung: 24.08.2016
(73) Patentinhaber: Siemens Aktiengesellschaft, 80333 München (DE)
(72) Erfinder: LUTZ, Benjamin, 76327 Pfinztal (DE); RUNDE, Stefan, 04277 Leipzig (DE); SCHOLZ, Andreas, 85716 Unterschleissheim (DE)
(86) Internationale Anmeldenummer: PCT/EP2014/073673
(87) Internationale Veröffentlichungsnummer: WO 2015/082156

(56) Entgegenhaltungen:
- DE-A1- 10 353 051
- DE-A1-102005 047 543

## Beschreibung

Die vorliegende Erfindung betrifft eine Vorrichtung zur Änderung von Betriebseinstellungen einer technischen Anlage und eine technische Anlage mit einer solchen Vorrichtung. Des Weiteren betrifft die vorliegende Erfindung ein Verfahren zur Änderung von Betriebseinstellungen einer technischen Anlage sowie ein Computerprogrammprodukt zur Durchführung eines solchen Verfahrens.

In bisherigen technischen Anlagen werden Prozesse in einer Engineering Station (ES) projektiert. Diese Prozesse werden an Automatisierungsstationen und Operatorstationen übertragen. Unter einer Automatisierungsstation wird die Rechenstation verstanden, die für die automatische Steuerung der Prozesse verantwortlich ist. Unter einer Operatorstation wird die Rechenstation verstanden, an der der Operator oder Anlagenfahrer die automatische Steuerung der Prozesse überwachen und sich anzeigen lassen kann. Die Automatisierungs- (AS) und Operatorstation (OS) spezifischen Anteile der Prozesse werden kompiliert und in die entsprechenden AS und OS übertragen. Änderungen an den Prozessen haben auch ein Update, d.h. eine Kompilierung, Übertragung, etc., der AS und OS zur Folge.

Um mögliche Änderungen der Prozesse auf ihren Nutzen zu untersuchen, müssen entweder aufwendige Simulationen durchgeführt, oder eine Re-Projektierung in der Engineering Station der AS/OS mit anschließender Übertragung in die Anlage, wie oben beschrieben, vorgenommen werden.

Eine detaillierte Simulation durchzuführen ist zeit- und kostenaufwendig und insbesondere für eine schnelle Überprüfung von kleineren Verbesserungsmöglichkeiten oder -ideen ungeeignet, bzw. in vielen Fällen sogar nicht möglich, da der Status von manchen Anlagen durch unzählige Umbauten unbekannt ist und mühevoll rekonstruiert werden müsste.

Generell ist jede Re-Projektierung einer Anlage mit einem Update-At-Run, also einer Aktualisierung während des laufenden Betriebs, aufwendig und riskant. Ein Nutzen einer möglichen Änderung kann daher oft erst evaluiert werden, wenn die implementierte Änderung zahlreiche Tests durchlaufen hat, um das Risiko eines Produktionsausfalls, insbesondere bei kontinuierlich betriebenen Anlagen, zu minimieren.

DE 10 2005 047 543 A1 offenbart ein Verfahren bzw. eine Vorrichtung zur Simulation eines Steuerungs- und/oder Maschinenverhaltens von Werkzeug- oder Produktionsmaschinen, wobei Daten über die Werkzeug- oder Produktionsmaschinen von dieser zu einer Simulationseinrichtung mittels eines Intranets und/oder mittels eines Internets übertragen werden. Die Daten können automatisch zur Simulationseinrichtung übertragen werden, wobei insbesondere zumindest nach der Änderung eines Datums aus der Menge der Daten zumindest dieses Datum zur Simulationseinrichtung übertragen wird.

DE 103 53 051 A1 beschreibt ein Verfahren zur Simulation einer Automatisierungsanlage. Dabei tauscht ein Kommunikationsgerät zur Bedienung und Beobachtung der Automatisierungsanlage Daten mit dieser aus. Die Automatisierungsanlage wird in einem Anlagesimulator nachgebildet. Zur Simulation wird das Kommunikationsgerät mit dem Anlagensimulator verbunden und tauscht mit diesem Daten aus.

Vor diesem Hintergrund besteht eine Aufgabe der vorliegenden Erfindung darin, eine Möglichkeit zu schaffen, mögliche Änderungen von Prozessen einer Anlage auf einfache Weise zu testen, ohne den laufenden Betrieb einer Anlage zu gefährden.

Demgemäß wird eine Vorrichtung gemäß Anspruch 1 zur Änderung von Betriebseinstellungen einer technischen Anlage vorgeschlagen. Die technische Anlage weist eine Steuereinrichtung auf, welche dazu eingerichtet ist, eine Mehrzahl von Funktionseinheiten der technischen Anlage basierend auf zumindest einer Mehrzahl von Eingangsparametern mittels der Betriebseinstellungen zu steuern.

Die vorgeschlagene Vorrichtung basiert auf der Idee, basierend auf tatsächlich in der technischen Anlage vorhandenen Eingangsparametern parallel zum laufenden Betrieb der Anlage Prozesse zu simulieren und an diesen Prozessen Änderungen durchzuführen. Da vorhandene Eingangsparameter der technischen Anlage verwendet werden, ist zum einen keine aufwendige Simulation der gesamten Anlage erforderlich, da die vorhandenen Eingangsparameter nicht in der Simulation erzeugt werden müssen. Zum anderen kann auf diese Weise die Simulation einzelner Prozesse durchgeführt werden, ohne die gesamte Anlage zu simulieren. Des Weiteren erfolgt die Simulation dieser einzelnen Prozesse sehr realitätsnah, da eben tatsächlich vorhandene Eingangsparameter verwendet werden.

Eine technische Anlage kann eine Mehrzahl von Prozessen aufweisen. Die einzelnen Prozesse wiederum werden durch eine oder mehrere Funktionseinheiten realisiert. Funktionseinheiten können in diesem Zusammenhang Maschinen, Apparate oder Vorrichtungen sein, die die Prozesse durchführen. Die Funktionseinheiten benötigen für ihren Ablauf Eingangsparameter. Diese Eingangsparameter können Werte oder sonstige Angaben sein, um die Funktionseinheiten mit den nötigen Eingaben zu versorgen. Zusätzlich sind für eine Funktionseinheit verschiedene Betriebseinstellungen vorgesehen, die den Prozessabschnitt, der durch die Funktionseinheit realisiert wird, zu definieren. Diese Betriebseinstellungen regeln oder steuern also die Abläufe innerhalb der Funktionseinheit.

Die Simulationseinheit simuliert zumindest eine Funktionseinheit. Es können auch mehrere Funktionseinheiten eines Prozesses oder auch mehrere Prozesse simuliert werden. Dies erfolgt immer auf Eingangsparametern, die von der Anlage direkt erhalten werden.

Zu Beginn verwendet die Simulationseinheit üblicherweise Betriebseinstellungen, wie sie auch in der aktuellen Anlagenkonfiguration verwendet werden. Die Änderungseinheit kann diese Betriebseinstellungen variieren. In der Simulationseinheit wird dann die Funktionseinheit bzw. der damit verbundene Prozess parallel zum laufenden Betrieb der Anlage mit veränderten Betriebseinstellungen simuliert. Da aktuelle Eingangsparameter der Anlage verwendet werden, kann das Ergebnis der Simulation, also die Ausgangsparameter der Funktionseinheit bzw. des Prozesses, einfach zu einer Bewertung der geänderten Betriebseinstellungen herangezogen werden.

Bei einer positiven Bewertung können die geänderten Betriebseinstellungen an die Steuereinrichtung der Anlage, z.B. eine Automatisierungsstation, übertragen werden. Der Betrieb der Anlage kann direkt mit den geänderten Betriebseinstellungen, die bereits durch die Simulationseinheit getestet sind, weitergeführt werden.

Gemäß einer Ausführungsform ist die Änderungseinheit dazu eingerichtet, die Betriebseinstellungen mehrmals zu ändern und eine Mehrzahl von geänderten Betriebseinstellungen an die Simulationseinheit bereitzustellen, und ist die Bewertungseinheit dazu eingerichtet, die auf den geänderten Betriebseinstellungen basierenden Ausgangsparameter der zumindest einen durch die Simulationseinheit simulierten Funktionseinheit für jede der Mehrzahl von geänderten Betriebseinstellungen zu bewerten.

Die Simulationseinheit kann mehrere geänderte Betriebseinstellungen testen und durch die Ausgangsparameter durch die Bewertungseinheit bewerten lassen. Auf diese Weise können viele mögliche Änderungen vorgenommen und getestet werden, bevor diese an die Anlage übertragen werden. Somit wird ein Ausfall der Anlage durch falsche oder fehlerhafte Betriebseinstellungen minimiert.

Gemäß einer weiteren Ausführungsform ist der Ausgang dazu eingerichtet, eine der Mehrzahl von geänderten Betriebseinstellungen basierend auf der Bewertung an die Steuereinrichtung bereitzustellen.

Die Bewertung kann beispielsweise einen Vergleich zwischen verschiedenen simulierten Betriebseinstellungen bzw. den daraus resultierenden Ausgangsparametern beinhalten. Basierend auf diesem Vergleich können dann die entsprechenden als am besten bewerteten Betriebseinstellungen an die Steuereinrichtung weitergegeben werden. Die Bewertung kann anhand verschiedener Kategorien erfolgen. Möglich ist beispielsweise der Vergleich mit einem Schwellwert. Ebenfalls ist ein direkter Vergleich zwischen den Ausgangsparametern möglich. Eine andere Möglichkeit besteht darin, dass ein bestimmter Wert erreicht werden muss, so dass das Vergleichsergebnis in diesem Fall ein true- oder false-Wert wäre.

Gemäß einer weiteren Ausführungsform ist der Eingang zum Empfangen von aktuellen Ausgangsparametern der technischen Anlage eingerichtet.

Zusätzlich zu den aktuellen Eingangsparametern können auch die aktuellen Ausgangsparameter der technischen Anlage direkt abgegriffen werden.

Gemäß einer weiteren Ausführungsform ist die Bewertungseinheit dazu eingerichtet, die auf den geänderten Betriebseinstellungen basierenden Ausgangsparameter mit den aktuellen Ausgangsparametern der Funktionseinheit der technischen Anlage zu vergleichen, und die geänderten Betriebseinstellungen basierend auf diesem Vergleich zu bewerten.

Statt einen Vergleich zwischen verschiedenen geänderten Betriebseinstellungen durchzuführen, kann auch ein Vergleich zwischen der gerade in der Anlage verwendeten Funktionseinheit mit den zugehörigen Betriebseinstellungen sowie einer simulierten Funktionseinheit mit zugehörigen geänderten Betriebseinstellungen durchgeführt werden. Dies geschieht durch Vergleich der Ausgangsparameter der simulierten Funktionseinheit und der Ausgangsparameter der tatsächlich aktuell verwendeten Funktionseinheit. Auf diese Weise können Veränderungen direkt mit dem aktuell laufenden System verglichen werden.

Die Simulationseinheit ist dazu eingerichtet, eine Mehrzahl von geänderten Betriebseinstellungen der zumindest einen Funktionseinheit parallel zu simulieren, und die Bewertungseinheit ist dazu eingerichtet, Ausgangsparameter der Funktionseinheit basierend auf der Mehrzahl von geänderten Betriebseinstellungen zu bewerten.

Es kann auch eine Mehrzahl von Änderungen gleichzeitig parallel simuliert und bewertet werden. Auf diese Weise können verschiedene Änderungen der Betriebseinstellungen gleichzeitig getestet werden.

Gemäß einer weiteren Ausführungsform ist die Bewertungseinheit dazu eingerichtet, einen Vergleich der Ausgangsparameter der Funktionseinheiten basierend auf der Mehrzahl von geänderten Betriebseinstellungen durchzuführen.

Eine einfache Möglichkeit der Bewertung besteht in einem Vergleich der verschiedenen Ausgangsparameter. Dieser Vergleich kann entweder unter den simulierten Funktionseinheiten oder zwischen diesen und der tatsächlich verwendeten Funktionseinheit durchgeführt werden.

Gemäß einer weiteren Ausführungsform ist die Vorrichtung eine Operatorstation einer technischen Anlage.

Wie bereits oben erläutert, handelt es sich bei einer Operatorstation um eine Rechenstation, an der der Anlagenfahrer bzw. der Operator die technische Anlage überwachen kann. An dieser können jedoch keine Änderungen an der Anlage direkt vorgenommen werden, sondern diese werden erst an die Steuereinrichtung der Anlage, beispielsweise eine Automatisierungsstation, übertragen. Von dieser erfolgt dann die Umsetzung der geänderten Betriebseinstellungen in der Anlage.

Gemäß einer weiteren Ausführungsform weist die Vorrichtung eine Anzeigeeinrichtung auf, die dazu eingerichtet ist, die Funktionseinheiten graphisch darzustellen.

Um einem Benutzer die Benutzung der Vorrichtung zu vereinfachen, ist eine Anzeigeeinrichtung vorgesehen. Auf dieser können die Funktionseinheiten sowie die Eingangsparameter, veränderten Betriebseinstellungen und Ausgangsparameter graphisch dargestellt werden. Beispielsweise kann der Benutzer, z.B. der Operator, die einzelnen Elemente als graphische Elemente auswählen und zusammenfügen.

Gemäß einer weiteren Ausführungsform weisen die Funktionseinheiten Logikeinheiten auf.

Die Funktionseinheiten können auch komplexere Untereinheiten aufweisen. Es können im Rahmen der Änderung der Betriebseinstellungen auch einzelne Einheiten einer Funktionseinheit geändert werden. In diesem Fall umfassen die Betriebseinstellungen auch Untereinheiten der Funktionseinheit.

Gemäß einer weiteren Ausführungsform ist die Simulationseinheit dazu eingerichtet, Continous Function Chart zu verwenden.

Continous Function Chart (CFC) ist eine Programmiersprache für Speicherprogrammierbare Steuerung. Solche CFC-Einheiten sind in den Automatisierungsstationen bereits vorhanden. Mit der Simulationseinheit kann der Benutzer auf die bestehenden CFC-Einheiten zugreifen und in der Operatorstation durch die Vorrichtung verwendet werden. Die von der Operatorstation ausgeführten CFC-Einheiten nehmen keinen Einfluss auf das Anlagenverhalten und ermöglichen für einen Bewertungsvergleich eine parallele Ausführung zu den CFC-Einheiten der Automatisierungsstation. Für die parallele Ausführung von CFC-Einheiten in der Vorrichtung können, wie bereits dargelegt, auf dieselben Eingabe- und Ausgabedaten wie in den CFC-Einheiten der Automatisierungsstation zugegriffen werden. Gemäß einem weiteren Aspekt wird eine technische Anlage vorgeschlagen. Die technische Anlage weist eine Mehrzahl von Funktionseinheiten, eine Steuereinrichtung, welche dazu eingerichtet ist, basierend auf zumindest einer Mehrzahl von Eingangsparametern mittels festgelegten Betriebseinstellungen die Mehrzahl von Funktionseinheiten zu steuern, und eine Vorrichtung mit den oben beschriebenen Merkmalen zur Änderung von Betriebseinstellungen der technischen Anlage auf.

Gemäß einer Ausführungsform ist die technische Anlage eine Prozessanlage.

In einer Prozessanlage, die beispielsweise zur Herstellung von Produkten verwendet wird, können mehrere Prozesse gleichzeitig ablaufen. Jeder Prozess kann eine oder mehrere Funktionseinheiten benötigen.

Gemäß einem weiteren Aspekt wird ein Verfahren gemäß Anspruch 13 zur Änderung von Betriebseinstellungen einer technischen Anlage vorgeschlagen, wobei die technische Anlage eine Steuereinrichtung aufweist, welche dazu eingerichtet ist, eine Mehrzahl von Funktionseinheiten der technischen Anlage basierend auf zumindest einer Mehrzahl von Eingangsparametern mittels der Betriebseinstellungen zu steuern.

Weiterhin wird ein Computerprogrammprodukt vorgeschlagen, welches auf einer programmgesteuerten Einrichtung die Durchführung des wie oben erläuterten Verfahrens veranlasst.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Die für die vorgeschlagene Vorrichtung beschriebenen Ausführungsformen und Merkmale gelten für das vorgeschlagene Verfahren entsprechend.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
- Fig. 1: zeigt eine schematische Ansicht eines Ausführungsbeispiels einer Vorrichtung zur Änderung von Betriebseinstellungen einer technischen Anlage;
- Fig. 2: zeigt eine schematische Ansicht eines Ausführungsbeispiels einer Anzeigeeinrichtung der Vorrichtung von Fig. 1; und
- Fig. 3: zeigt ein Ausführungsbeispiel eines Verfahrens zur Änderung von Betriebseinstellungen einer technischen Anlage.

In den Figuren sind gleiche oder funktionsgleiche Elemente mit denselben Bezugszeichen versehen worden, sofern nichts anderes angegeben ist.

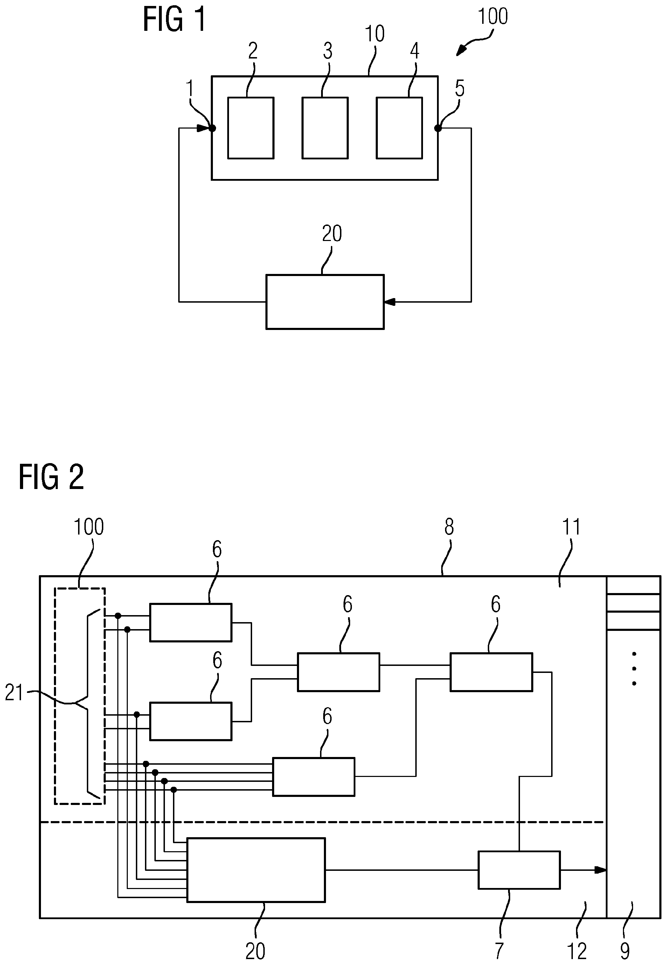

Figuren 1 und 2 zeigen eine schematische Darstellung einer Vorrichtung 10 zur Änderung von Betriebseinstellungen einer technischen Anlage 100 sowie eine Anzeigevorrichtung 8 der Vorrichtung 10. Die Vorrichtung 10 kann beispielsweise Teil einer Operatorstation (OS) sein.

Die technische Anlage 100 weist eine Steuereinrichtung 20 auf. Die Steuereinrichtung 20 kann beispielsweise eine Automatisierungsstation (AS) sein. Die Steuereinrichtung 20 ist dazu eingerichtet, eine Mehrzahl von Funktionseinheiten der technischen Anlage 100 basierend auf zumindest einer Mehrzahl von Eingangsparametern 21 mittels der Betriebseinstellungen zu steuern. Eine einzelne Funktionseinheit kann einen Prozess der technischen Anlage 100 realisieren. Es können auch mehrere Funktionseinheiten für einen Prozess benötigt werden. Die Betriebseinstellungen der Funktionseinheit können durch verschiedene Untereinheiten der Funktionseinheit dargestellt sein.

Die Vorrichtung 10 weist einen Eingang 1 auf, um Eingangsparameter 21 der technischen Anlage 100 bzw. der Funktionseinheit zu empfangen. Die Eingangsparameter können beispielsweise von der Steuereinrichtung 20 empfangen werden. Bei den Eingangsparametern handelt es sich um Werte, auf denen der gerade in der technischen Anlage tatsächlich stattfindende Prozess basiert.

In einer Simulationseinheit 2 wird zumindest eine Funktionseinheit der Mehrzahl von Funktionseinheiten der technischen Anlage 100 basierend auf diesen Eingangsparametern 21 simuliert. In einer Änderungseinheit 3 können verschiedene Betriebseinstellungen der Funktionseinheit geändert werden. Diese geänderten Betriebseinstellungen werden dann an die Simulationseinheit 2 bereitgestellt.

In der Simulationseinheit 2 wird dann die Funktionseinheit mit den geänderten Betriebseinstellungen simuliert und Ausgangsparameter erzeugt. Eine Bewertungseinheit 4 bewertet diese Ausgangsparameter. Sofern die Bewertung ergibt, dass die geänderten Betriebseinstellungen an die Steuereinrichtung 20 der technischen Anlage 100 übergeben werden sollen, um in der Anlage 100 implementiert zu werden, werden diese geänderten Betriebseinstellungen an einem Ausgang 5 an die Steuereinrichtung 20 bereitgestellt.

In Bezug auf Fig. 2 wird eine Anzeigeeinrichtung 8, die in der Vorrichtung 10 vorgesehen ist und deren Bedienung erleichtert, näher erläutert. Auf der Anzeigeeinrichtung werden die Vorgänge bzw. die Simulation, die durch die Vorrichtung 10 durchgeführt werden, graphisch dargestellt bzw. visualisiert. Die Anzeigeeinrichtung 10 ist beispielsweise Teil eines Displays einer Operatorstation. Ein Bediener kann anhand der Anzeigevorrichtung 8 Vorgänge oder Abläufe der Vorrichtung 10 steuern.

Aus einem Menü 9 können verschiedene Logikeinheiten 6 für die Funktionseinheit als CFC (Continous Function Chart) ausgewählt werden. Die Eingangsparameter 21 für die verschiedenen Logikeinheiten 6 werden von der technischen Anlage 100 erhalten.

In einem ersten Bildschirmbereich bzw. Simulationsbereich 11 können beispielsweise Änderungen an den Logikeinheiten vorgenommen werden. In einem zweiten Bildschirmbereich bzw. Simulationsbereich 12 können wahlweise weitere Simulationen durchgeführt oder der aktuelle Ablauf der Funktionseinheit der technischen Anlage 100 dargestellt werden. Ein Vergleieher 7 bewertet die Ausgangsparameter des ersten Simulationsbereichs 11 und des zweiten Simulationsbereichs 12.

In der Fig. 2 ist beispielhaft dargestellt, dass die Eingangsparameter 21 in dem zweiten Simulationsbereich 12 an die Steuereinrichtung 20 weitergegeben und entsprechende Ausgangsparameter an den Vergleicher 7 ausgegeben werden. Dies ist allerdings nur eine beispielhafte Ausführungsform, da in dem zweiten Simulationsbereich 12 auch eine Simulation durchgeführt werden kann. Alternativ kann auch eine Lookup-Table anstelle der Steuereinrichtung 20 verwendet werden, der die aktuellen Ausgangsparameter der technischen Anlage 100 entnommen werden können.

Auf diese Weise können Operatoren, d.h. Anlagenfahrer, Ideen, Optimierungen, Verbesserungen, neue Kennzahlen (KPIs), neue Alarme, usw. in der OS testweise implementieren und testen, basierend auf realen Anlagendaten, ohne einen Einfluss auf die reale Prozessautomatisierung, die in der technischen Anlage 100 vorhanden ist, zu nehmen. Hierfür stehen alle von der AS in einem CFC bereitgestellten Ein- und Ausgänge zur Verfügung. Der Operator muss hierfür über keine speziellen Kenntnisse oder eine Simulationsumgebung verfügen, da dieser Ansatz auf realen Anlagendaten basiert. Weiterhin können gleichzeitig mehrere Realisierungsalternativen zeitgleich auf einer OS evaluiert werden, bevor man die für den Prozess optimale Variante auf einer AS integriert.

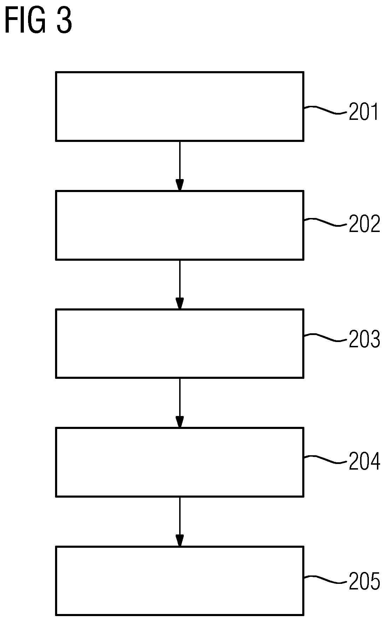

Fig. 3 zeigt ein Ablaufdiagramm eines beispielhaften Verfahrens zur Änderung von Betriebseinstellungen einer technischen Anlage 100, wie sie z.B. in Figuren 1 und 2 gezeigt ist.

In einem ersten Schritt 201 wird zumindest ein Eingangsparameter der Mehrzahl von Eingangsparametern 21 empfangen.

In einem zweiten Schritt 202 wird zumindest eine Funktionseinheit der Mehrzahl von Funktionseinheiten basierend auf dem zumindest einen empfangenen Eingangsparameter simuliert.

Hierbei können geänderte Betriebseinstellungen verwendet werden, die in einem dritten Schritt 203 geändert werden, wobei der dritte Schritt 203 zeitgleich mit dem zweiten Schritt 202 ablaufen kann.

Im Anschluss werden in einem vierten Schritt 204 die geänderten Betriebseinstellungen basierend auf den Ausgangsparametern der zumindest einen simulierten Funktionseinheit bewertet. Basierend auf dieser Bewertung werden in einem fünften Schritt 205 die geänderten Betriebseinstellungen an die Steuereinrichtung 20, wie in Figuren 1 und 2, bereitgestellt.

## Patentansprüche

1. Vorrichtung (10) zur Änderung von Betriebseinstellungen einer technischen Anlage (100), wobei die technische Anlage (100) eine Steuereinrichtung (20) aufweist, welche dazu eingerichtet ist, eine Mehrzahl von Funktionseinheiten der technischen Anlage (100) basierend auf zumindest einer Mehrzahl von Eingangsparametern (21) mittels der Betriebseinstellungen zu steuern, mit:
einem Eingang (1) zum Empfangen von zumindest einem Eingangsparameter der Mehrzahl von Eingangsparametern (21),
einer Simulationseinheit (2) zum Simulieren von zumindest einer Funktionseinheit der Mehrzahl von Funktionseinheiten basierend auf dem zumindest einen empfangenen Eingangsparameter,
einer Änderungseinheit (3) zum Ändern der Betriebseinstellungen und zum Bereitstellen von geänderten Betriebseinstellungen an die Simulationseinheit (2), wobei die Simulationseinheit (2) dazu eingerichtet ist, eine Mehrzahl von geänderten Betriebseinstellungen der zumindest einen Funktionseinheit parallel zu simulieren,
einer Bewertungseinheit (4) zum Bewerten von auf den geänderten Betriebseinstellungen basierenden Ausgangsparametern der zumindest einen durch die Simulationseinheit (2) simulierten Funktionseinheit, wobei die Bewertungseinheit (4) dazu eingerichtet ist, Ausgangsparameter der Funktionseinheit basierend auf der Mehrzahl von geänderten Betriebseinstellungen zu bewerten, und
einem Ausgang (5) zum Bereitstellen der geänderten Betriebseinstellungen an die Steuereinrichtung (20) basierend auf der Bewertung.

2. Vorrichtung (10) nach Anspruch 1,
**dadurch gekennzeichnet,**
**dass** die Änderungseinheit (3) dazu eingerichtet ist, die Betriebseinstellungen mehrmals zu ändern und eine Mehrzahl von geänderten Betriebseinstellungen an die Simulationseinheit (2) bereitzustellen, und
**dass** die Bewertungseinheit (4) dazu eingerichtet ist, die auf den geänderten Betriebseinstellungen basierenden Ausgangsparameter der zumindest einen durch die Simulationseinheit (2) simulierten Funktionseinheit für jede der Mehrzahl von geänderten Betriebseinstellungen zu bewerten.

3. Vorrichtung (10) nach Anspruch 2,
**dadurch gekennzeichnet,**
**dass** der Ausgang (5) dazu eingerichtet ist, einer der Mehrzahl von geänderten Betriebseinstellungen basierend auf der Bewertung an die Steuereinrichtung (20) bereitzustellen.

4. Vorrichtung (10) nach einem der Ansprüche 1 - 3,
**dadurch gekennzeichnet,**
**dass** der Eingang (1) zum Empfangen von aktuellen Ausgangsparametern der technischen Anlage (100) eingerichtet ist.

5. Vorrichtung (10) nach Anspruch 4,
**dadurch gekennzeichnet,**
**dass** die Bewertungseinheit (4) dazu eingerichtet ist, die auf den geänderten Betriebseinstellungen basierenden Ausgangsparameter mit den aktuellen Ausgangsparametern der Funktionseinheit der technischen Anlage (100) zu vergleichen, und die geänderten Betriebseinstellungen basierend auf diesem Vergleich zu bewerten.

6. Vorrichtung (10) nach einem der Ansprüche 1 - 5
**dadurch gekennzeichnet,**
**dass** die Bewertungseinheit (4) dazu eingerichtet ist, einen Vergleich der Ausgangsparameter der Funktionseinheiten basierend auf der Mehrzahl von geänderten Betriebseinstellungen durchzuführen.

7. Vorrichtung (10) nach einem der Ansprüche 1 - 6,
**dadurch gekennzeichnet,**
**dass** die Vorrichtung (10) eine Operatorstation einer technischen Anlage (100) ist.

8. Vorrichtung (10) nach einem der Ansprüche 1 - 7, **gekennzeichnet durch**
eine Anzeigeeinrichtung (8), die dazu eingerichtet ist, die Funktionseinheiten graphisch darzustellen.

9. Vorrichtung (10) nach einem der Ansprüche 1 - 8,
**dadurch gekennzeichnet,**
**dass** die Funktionseinheiten Logikeinheiten aufweisen.

10. Vorrichtung (10) nach einem der Ansprüche 1 - 9,
**dadurch gekennzeichnet,**
**dass** die Simulationseinheit (2) dazu eingerichtet ist, Continous Function Chart zu verwenden.

11. Technische Anlage (100) mit:
einer Mehrzahl von Funktionseinheiten,
einer Steuereinrichtung (20), welche dazu eingerichtet ist,
basierend auf zumindest einer Mehrzahl von Eingangsparametern mittels festgelegten Betriebseinstellungen die Mehrzahl von Funktionseinheiten zu steuern, und
einer Vorrichtung (10) nach einem der Ansprüche 1 - 10 zur Änderung von Betriebseinstellungen der technischen Anlage (100) .

12. Technische Anlage (100) nach Anspruch 11,
**dadurch gekennzeichnet,**
**dass** die technische Anlage (100) eine Prozessanlage ist.

13. Verfahren zur Änderung von Betriebseinstellungen einer technischen Anlage (100), wobei die technische Anlage eine Steuereinrichtung (20) aufweist, welche dazu eingerichtet ist, eine Mehrzahl von Funktionseinheiten der technischen Anlage (100) basierend auf zumindest einer Mehrzahl von Eingangsparametern (21) mittels der Betriebseinstellungen zu steuern, mit:
Empfangen (201) von zumindest einem Eingangsparameter der Mehrzahl von Eingangsparametern (21),
Simulieren (202) von zumindest einer Funktionseinheit der Mehrzahl von Funktionseinheiten basierend auf dem zumindest einen empfangenen Eingangsparameter durch eine Simulationseinheit (2),
Ändern (203) der Betriebseinstellungen und Bereitstellen der geänderten Betriebseinstellungen an die Simulationseinheit (2) durch eine Änderungseinheit (3), wobei die Simulationseinheit (2) dazu eingerichtet ist, eine Mehrzahl von geänderten Betriebseinstellungen der zumindest einen Funktionseinheit parallel zu simulieren,
Bewerten (204) von auf den geänderten Betriebseinstellungen basierenden Ausgangsparametern der zumindest einen simulierten Funktionseinheit durch eine Bewertungseinheit (4), wobei die Bewertungseinheit (4) dazu eingerichtet ist, Ausgangsparameter der Funktionseinheit basierend auf der Mehrzahl von geänderten Betriebseinstellungen zu bewerten und
Bereitstellen (205) der geänderten Betriebseinstellungen an die Steuereinrichtung (20) basierend auf der Bewertung.

14. Computerprogrammprodukt, welches auf einer programmgesteuerten Einrichtung die Durchführung des Verfahrens nach Anspruch 13 veranlasst.

## Claims

1. Device (10) for changing operating settings of a technical facility (100), wherein the technical facility (100) has a controller (20) that is configured so as to control a multiplicity of functional units of the technical facility (100), based on at least a multiplicity of input parameters (21), by way of the operating settings, having:
an input (1) for receiving at least one input parameter of the multiplicity of input parameters (21),
a simulation unit (2) for simulating at least one functional unit of the multiplicity of functional units based on the at least one received input parameter,
a changing unit (3) for changing the operating settings and for providing changed operating settings to the simulation unit (2), wherein the simulation unit (2) is configured so as to simulate a multiplicity of changed operating settings of the at least one functional unit in parallel,
an evaluation unit (4) for evaluating output parameters, based on the changed operating settings, of the at least one functional unit simulated by the simulation unit (2), wherein the evaluation unit (4) is configured so as to evaluate output parameters of the functional unit based on the multiplicity of changed operating settings, and
an output (5) for providing the changed operating settings to the controller (20) based on the evaluation.

2. Device (10) according to Claim 1,
**characterized**
**in that** the changing unit (3) is configured so as to change the operating settings multiple times and to provide a multiplicity of changed operating settings to the simulation unit (2), and
**in that** the evaluation unit (4) is configured so as to evaluate the output parameters, based on the changed operating settings, of the at least one functional unit simulated by the simulation unit (2) for each of the multiplicity of changed operating settings.

3. Device (10) according to Claim 2,
**characterized**
**in that** the output (5) is configured so as to provide one of the multiplicity of changed operating settings to the controller (20) based on the evaluation.

4. Device (10) according to one of Claims 1 - 3,
**characterized**
**in that** the input (1) is configured so as to receive current output parameters of the technical facility (100).

5. Device (10) according to Claim 4,
**characterized**
**in that** the evaluation unit (4) is configured so as to compare the output parameters, based on the changed operating settings, with the current output parameters of the functional unit of the technical facility (100), and to evaluate the changed operating settings based on this comparison.

6. Device (10) according to one of Claims 1 - 5,
**characterized**
**in that** the evaluation unit (4) is configured so as to perform a comparison of the output parameters of the functional units based on the multiplicity of changed operating settings.

7. Device (10) according to one of Claims 1 - 6,
**characterized**
**in that** the device (10) is an operator station of a technical facility (100).

8. Device (10) according to one of Claims 1 - 7,
**characterized by**
a display apparatus (8) that is configured so as to graphically display the functional units.

9. Device (10) according to one of Claims 1 - 8,
**characterized**
**in that** the functional units have logic units.

10. Device (10) according to one of Claims 1 - 9, **characterized**
**in that** the simulation unit (2) is configured so as to use a continuous function chart.

11. Technical facility (100) having:
a multiplicity of functional units,
a controller (20) that is configured so as to control the multiplicity of functional units, based on at least a multiplicity of input parameters, by way of defined operating settings, and
a device (10) according to one of Claims 1 - 10 for changing operating settings of the technical facility (100).

12. Technical facility (100) according to Claim 11,
**characterized**
**in that** the technical facility (100) is a processing facility.

13. Method for changing operating settings of a technical facility (100), wherein the technical facility has a controller (20) that is configured so as to control a multiplicity of functional units of the technical facility (100), based on at least a multiplicity of input parameters (21), by way of the operating settings, comprising:
receiving (201) at least one input parameter of the multiplicity of input parameters (21),
simulating (202) at least one functional unit of the multiplicity of functional units based on the at least one received input parameter by way of a simulation unit (2),
changing (203) the operating settings and providing the changed operating settings to the simulation unit (2) by way of a changing unit (3), wherein the simulation unit (2) is configured so as to simulate a multiplicity of changed operating settings of the at least one functional unit in parallel,
evaluating (204) output parameters, based on the changed operating settings, of the at least one simulated functional unit by way of an evaluation unit (4), wherein the evaluation unit (4) is configured so as to evaluate output parameters of the functional unit based on the multiplicity of changed operating settings, and
providing (205) the changed operating settings to the controller (20) based on the evaluation.

14. Computer program product that prompts the performance of the method according to Claim 13 on a program-controlled apparatus.

## Revendications

1. Dispositif (10) permettant de modifier des réglages opérationnels d'une installation technique (100), l'installation technique (100) comprenant un dispositif de commande (20) qui est conçu pour commander une pluralité d'unités fonctionnelles de l'installation technique (100) à l'aide de réglages opérationnels sur la base d'au moins une pluralité de paramètres d'entrée (21), comprenant :
une entrée (1) destinée à recevoir au moins un paramètre d'entrée de la pluralité de paramètres d'entrée (21),
une unité de simulation (2) permettant de simuler au moins une unité fonctionnelle de la pluralité d'unités fonctionnelles sur la base de l'au moins un paramètre d'entrée reçu,
une unité de modification (3) permettant de modifier les réglages opérationnels et de fournir des réglages opérationnels modifiés à l'unité de simulation (2), l'unité de simulation (2) étant conçue pour simuler en parallèle une pluralité de réglages opérationnels modifiés de l'au moins une unité fonctionnelle,
une unité d'évaluation (4) permettant d'évaluer des paramètres de sortie, basés sur les réglages opérationnels modifiés, de l'au moins une unité fonctionnelle simulée par l'unité de simulation (2), l'unité d'évaluation (4) étant conçue pour évaluer des paramètres de sortie de l'unité fonctionnelle sur la base de la pluralité de réglages opérationnels modifiés, et
une sortie (5) permettant de fournir les réglages opérationnels modifiés au dispositif de commande (20) sur la base de l'évaluation.

2. Dispositif (10) selon la revendication 1,
**caractérisé en ce que** l'unité de modification (3) est conçue pour modifier les réglages opérationnels plusieurs fois et fournir une pluralité de réglages opérationnels modifiés à l'unité de simulation (2), et
**en ce que** l'unité d'évaluation (4) est conçue pour évaluer les paramètres de sortie, basés sur les réglages opérationnels modifiés, de l'au moins une unité fonctionnelle simulée par l'unité de simulation (2) pour chacun de la pluralité des réglages opérationnels modifiés.

3. Dispositif (10) selon la revendication 2,
**caractérisé en ce que** la sortie (5) est conçue pour fournir un réglage de la pluralité de réglages opérationnels modifiés au dispositif de commande (20) sur la base de l'évaluation.

4. Dispositif (10) selon l'une des revendications 1 - 3,
**caractérisé en ce que** l'entrée (1) est conçue pour recevoir des paramètres de sortie actuels de l'installation technique (100).

5. Dispositif (10) selon la revendication 4,
**caractérisé en ce que** l'unité d'évaluation (4) est conçue pour comparer les paramètres de sortie basés sur les réglages opérationnels modifiés aux paramètres de sortie actuels de l'unité fonctionnelle de l'installation technique (100) et pour évaluer les réglages opérationnels modifiés sur la base de cette comparaison.

6. Dispositif (10) selon l'une des revendications 1 - 5,
**caractérisé en ce que** l'unité d'évaluation (4) est conçue pour réaliser une comparaison des paramètres de sortie des unités fonctionnelles sur la base de la pluralité de réglages opérationnels modifiés.

7. Dispositif (10) selon l'une des revendications 1 - 6,
**caractérisé en ce que** le dispositif (10) est un poste d'opérateur d'une installation technique (100).

8. Dispositif (10) selon l'une des revendications 1 - 7,
**caractérisé par** un dispositif d'affichage (8) qui est conçu pour représenter graphiquement les unités fonctionnelles.

9. Dispositif (10) selon l'une des revendications 1 - 8,
**caractérisé en ce que** les unités fonctionnelles comprennent des unités logiques.

10. Dispositif (10) selon l'une des revendications 1 - 9,
**caractérisé en ce que** l'unité de simulation (2) est conçue pour utiliser Continuous Function Chart.

11. Installation technique (100) comprenant :
une pluralité d'unités fonctionnelles,
un dispositif de commande (20) qui est conçu pour commander la pluralité d'unités fonctionnelles à l'aide de réglages opérationnels déterminés, sur la base d'au moins une pluralité de paramètres d'entrée, et
un dispositif (10) selon l'une des revendications 1 - 10 permettant de modifier des réglages opérationnels de l'installation technique (100).

12. Installation technique (100) selon la revendication 11,
**caractérisée en ce que** l'installation technique (100) est une installation de traitement.

13. Procédé de modification de réglages opérationnels d'une installation technique (100), l'installation technique comprenant un dispositif de commande (20) qui est conçu pour commander une pluralité d'unités fonctionnelles de l'installation technique (100) à l'aide des réglages opérationnels sur la base d'au moins une pluralité de paramètres d'entrée (21), comprenant :
la réception (201) d'au moins un paramètre d'entrée de la pluralité de paramètres d'entrée (21),
la simulation (202) d'au moins une unité fonctionnelle de la pluralité d'unités fonctionnelles sur la base de l'au moins un paramètre d'entrée reçu, par une unité de simulation (2),
la modification (203) des réglages opérationnels et la fourniture des réglages opérationnels modifiés à l'unité de simulation (2), par une unité de modification (3), l'unité de simulation (2) étant conçue pour simuler en parallèle une pluralité de réglages opérationnels modifiés de l'au moins une unité fonctionnelle,
l'évaluation (204) de paramètres de sortie, basés sur les réglages opérationnels modifiés, de l'au moins une unité fonctionnelle simulée, par une unité d'évaluation (4), l'unité d'évaluation (4) étant conçue pour évaluer des paramètres de sortie de l'unité fonctionnelle sur la base de la pluralité de réglages opérationnels modifiés, et
la fourniture (205) des réglages opérationnels modifiés au dispositif de commande (20) sur la base de l'évaluation.

14. Produit programme d'ordinateur faisant exécuter sur un dispositif commandé par programme le procédé selon la revendication 13.
